# EUROPEAN PATENT SPECIFICATION

(11) **EP 4 137 827 B1**
(45) Date of publication and mention of the grant of the patent: **05.02.2025**
(21) Application number: 21218200.0
(22) Date of filing: 29.12.2021
(51) Int. Cl.: G01R 31/12

(54) **SELF-CHECKING METHOD AND APPARATUS OF ARC DETECTION DEVICE IN POWER SYSTEM**
SELBSTPRÜFUNGSVERFAHREN UND GERÄT EINER LICHTBOGENDETEKTIONSVORRICHTUNG IN EINEM LEISTUNGSSYSTEM
PROCÉDÉ ET APPAREIL D'AUTOCONTRÔLE D'UN DISPOSITIF DE DÉTECTION D'ARC DANS UN SYSTÈME D'ALIMENTATION

(30) Priority: 17.08.2021 KR 20210108184
(43) Date of publication of application: 22.02.2023
(73) Proprietor: QIT Co., Ltd, Suwon-si 16226 (KR)
(72) Inventor: BAE, Joung Hwan, YONGIN-SI (KR); BAIK, Bo Hyun, YONGIN-SI (KR)
(74) Representative: Lavoix

(56) References cited:
- WO-A1-02/41330
- CN-A- 111 913 041
- CN-A- 111 913 041
- DE-A1- 10 210 326
- DE-A1- 102008 020 455
- DE-A1- 102008 037 006
- DE-A1- 102011 015 886
- DE-B3- 102017 110 259
- KR-B1- 101 542 538
- KR-B1- 101 542 538
- KR-B1- 102 049 425
- KR-B1- 102 049 425

## Description

### CROSS-REFERENCE TO RELATED APPLICATION

This application is based on and claims priority under 35 U.S.C. §119 to Korean Patent Application No. 10-2021-0108184, filed on August 17, 2021, in the Korean Intellectual Property Office.

### BACKGROUND

### 1. Field

One or more embodiments of the present disclosure relate to a method and apparatus for failure checking of an arc detection sensor device for detecting an arc in a power system using a high-power device.

KR101542538B1 relates to an arc detecting system of a distributing board with an optical fiber loop sensor.

KR102049425B1 concerns a method for self-diagnosing an arc detection sensor and a device thereof.

CN111913041A concerns an alternating-current switch cabinet arc light detection system and method, and relates to the field of switch cabinets.

The present disclosure is derived from a study conducted as part of a technological development project of the Ministry of Trade, Industry and Energy, and the Korea Institute of Energy Technology Evaluation and Planning. [Project Management No.: 20206910100020, Project Name: Development of Core Technology for Improving Grid-Connected PCS Reliability and Real Environment Demonstration]

### 2. Description of the Related Art

An arc discharge is often a problem when a high-power electric device is used. For example, an ultra-high voltage gas insulated switchgear (GIS) is an important high-power electric device used as a switchgear in a main circuit in a power plant or a substation. Because an ultra-high voltage GIS operates at a high-power level, high operational reliability is required, and thus a robust preventive checking device and mechanism are required.

When a problem occurs in an ultra-high voltage GIS, initially, partial discharge occurs, and insulation breakdown occurs progressively in the ultra-high voltage GIS according to the partial discharge. When the insulation breakdown accumulates in the ultra-high voltage GIS, a critical point of an accident is exceeded and a serious accident occurs. An arc occurs in a portion where the insulation breakdown occurs due to the partial discharge in the ultra-high voltage GIS. It is very important for a device for controlling a power system to initially detect such an arc, in order to ensure the reliability and safety of high-power heavy electric device.

When an arc detection sensor device initially operates stably but is used for a long time, the arc detection sensor device may not detect a minute malfunction or degradation of operational performance. When such a minute malfunction or degradation of operational performance continues, the reliability of the arc detection sensor device itself decreases gradually, and eventually, the arc detection sensor device mistakes a non-arc as an arc and causes an error that a failure has occurred in a system. Due to the error, the arc detection sensor device may unnecessarily stop the system. Alternatively, even when an arc occurs, the arc detection sensor device may not detect the arc correctly, and in this case, a serious accident may not be prevented in advance, thereby leading to a fatal consequence for the power system.

Accordingly, it is very important to ensure continuous normal operational performance even when an arc detection sensor device is used for a long time, in order to ensure the stability of a high voltage device or a heavy electric device.

### SUMMARY

According to the invention an arc detection device according to claim 1 and a self-checking method in an arc detection device according to claim 7 are provided. Optional embodiments are covered by the dependent claims.

The periodically generating of the self-checking optical signal by the processor may include, by the processor, periodically generating an event, generating the self-checking optical signal based on the generated event, and determining an amount of current flowing through an optical device to generate the self-checking optical signal, and generating the self-checking optical signal by controlling the determined amount of current to flow through the optical device.

The periodically generating of the self-checking optical signal by the processor may include, by the processor, periodically generating an event, generating the self-checking optical signal based on the generated event, and determining a voltage applied to an optical device to generate the self-checking optical signal, and generating the self-checking optical signal by controlling the determined voltage to be applied to the optical device.

The generating of the self-checking optical signal by the processor may include generating, by the processor, the self-checking optical signal having a duty of a predetermined value or longer to be distinguished from an arc signal.

The comparing of the stored reference self-checking data with the self-checking data corresponding to the light amount value of the optical signal corresponding to the received self-checking optical signal by the processor may include determining, by the processor, whether there is a difference of a predetermined value or more between the self-checking data and the reference self-checking data, and wherein the determining, by the processor, whether there is abnormality in any one of the optical sensor device, the transmission optical cable, and the reception optical cable includes, when there is the difference of the predetermined value or more between the self-checking data and the reference self-checking data, determining that there is abnormality in any one of the optical sensor device, the transmission optical cable, and the reception optical cable.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a view illustrating an arc detection system according to the prior art;
FIG. 2 is a view illustrating an arc detection self-checking apparatus, according to an embodiment of the present disclosure;
FIG. 3 is a view illustrating an arc detection self-checking apparatus, according to another embodiment of the present disclosure;
FIG. 4 is a view illustrating an optical sensor device, according to an embodiment of the present disclosure;
FIG. 5 is a block diagram illustrating an arc detection controller, according to an embodiment of the present disclosure;
FIG. 6 is a diagram illustrating a time when the arc detection controller generates a self-checking optical signal, according to an embodiment of the present disclosure; and
FIG. 7 is a flowchart illustrating a self-checking method of the arc detection controller, according to an embodiment of the present disclosure.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

The present disclosure will now be described more fully with reference to the accompanying drawings, in which embodiments of the present disclosure are shown. The present disclosure may, however, be embodied in many different forms and should not be construed as being limited to the embodiments set forth herein. Rather, these embodiments are provided so that this disclosure will be thorough and complete, and will fully convey the concept of the present disclosure to one of ordinary skill in the art. Like reference numerals in the drawings denote like elements. The terms used in the present specification are merely used to describe exemplary embodiments, and are not intended to limit the present disclosure. Singular forms are intended to include plural forms unless the context clearly indicates otherwise.

Because a high voltage device or a heavy electric device belonging to a high voltage power system operates at a high power level and thus the risk of an accident is high, a fairly high reliability is required. That is, it is essential for a user to detect a failure of devices belonging a power system within a short time or to predict a failure in advance by detecting an abnormal operation before the failure, in order to ensure the safety of the power system.

A representative example of a high voltage device or a heavy electric device includes an ultra-high voltage gas insulated switchgear (GIS). The ultra-high voltage GIS is used as a switchgear of a main circuit in a power plant or a substation. The ultra-high voltage GIS is a device that is mainly used at 100 kV or higher and has a high-power interruption capability. An ultra-high voltage GIS is a switchgear of a large-scale system having a high-power level, the ultra-high voltage GIS is expensive. Accordingly, high reliability is required to prevent a safety accident in advance so that the expensive device is not damaged.

In order to ensure the high reliability of an ultra-high voltage GIS as a switchgear, it is essential for a self-checking apparatus to continuously monitor whether insulation breakdown occurs. When a problem of insulation breakdown occurs in an ultra-high voltage GIS, initially, partial discharge occurs in an insulated portion. When the insulation breakdown develops progressively according to the partial discharge, eventually, a critical point of an accident is exceeded and a serious accident occurs.

In order to prevent insulation breakdown due to partial discharge in advance, it is necessary for a self-checking apparatus to continuously monitor whether an arc occurs in an opening/closing portion. In a portion where an arc occurs, ultra-high frequency (UHF) gas, light, and noise are simultaneously generated. In an ultra-high voltage GIS, a UHF detection method is used as a method for a self-checking apparatus to supervise and monitor partial discharge. However, the UHF detection method has a disadvantage in that the reliability is relatively low. By considering that an accident caused by abnormality in an electric power device is very large, it is essential to ensure the high reliability of an arc detection sensor device as a self-checking apparatus for detecting abnormality of a heavy electric device such as an ultra-high voltage GIS, particularly, a power device in which an arc due to partial discharge occurs such as an switchgear.

An arc detection sensor device using an optical sensor is mainly used as a system for sensing an arc in a heavy electric device in which an arc may occur such as an ultra-high voltage GIS. That is, the arc detection sensor device using the optical sensor prevents an accident in advance by detecting light of an arc caused by partial discharge by using the optical sensor.

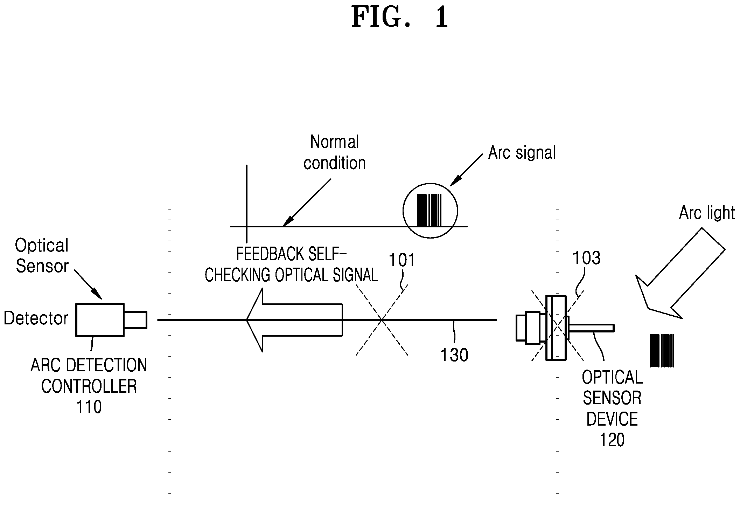

FIG. 1 is a view illustrating an arc detection system according to the prior art.

In FIG. 1, an optical sensor device 120 detects an arc caused by the progress of partial discharge in a heavy electric device (not shown), senses the arc as a signal, and transmits the signal to a cable 130. An arc detection controller 110 receives the transmitted signal, recognizes that the arc occurs in the heavy electric device, and generates a failure risk signal to avoid a serious accident.

However, when an arc occurs in the heavy electric device and the optical sensor device 120 detects the arc and transmits a signal to the arc detection controller 110, if the cable 130 is disconnected (101) for some reason, the arc detection controller 110 fails to recognize that the arc occurs. In this case, the arc detection controller 110 eventually fails to take necessary failure preventing measures. Accordingly, the disconnection of the cable 130 makes it impossible to prevent the entire power system from leading to a serious accident due to a high-power level of the heavy electric device.

As another example of an accident, the optical sensor device 120 itself may be out of order (103). When the optical sensor device 120 has a failure or a malfunction and thus fails to properly perform optical sensing, even though an arc occurs, the optical sensor device 120 fails to transmit a signal corresponding to the arc to the arc detection controller 110. Even in this case, as in the above example, failure preventing measures may not be taken and a serious accident may occur.

Accordingly, in order to prevent an accident in such a large-scale power system, a self-checking method and apparatus capable of monitoring whether the optical sensor device 120 properly operates and whether there is no disconnection in the cable 130 is required.

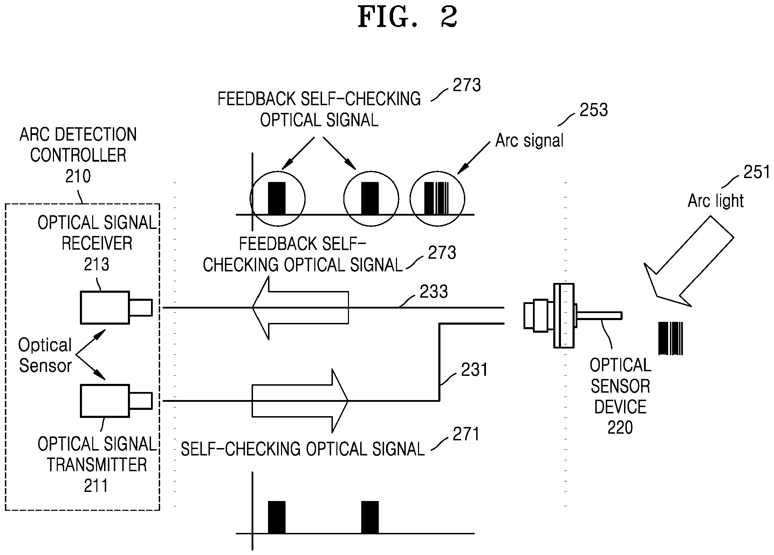

FIG. 2 is a view illustrating an arc detection self-checking apparatus, according to an embodiment of the present disclosure.

Referring to FIG. 2, in order to determine whether an arc detection operation is normally performed, an arc detection controller 210 transmits a self-checking optical signal 271 to an optical sensor device 220. It may be preferable that the self-checking optical signal 271 is transmitted for the self-checking purpose.

The optical sensor device 220 senses the received self-checking optical signal 271 through an optical sensor, and returns the self-checking optical signal 271 to the arc detection controller 210 through an optical signal transmitter of the optical sensor device 220. The optical sensor device 220 processes the self-checking optical signal 271. For convenience, a self-checking optical signal processed and then returned to the arc detection controller 210 by the optical sensor device 220 is referred to as a feedback self-checking optical signal 273. In an embodiment, the feedback self-checking optical signal 273 may be mixed with an arc signal 253 and may be transmitted to the arc detection controller 210. The feedback self-checking optical signal 273 may have different properties from the self-checking optical signal 271, due to the signal processing of the optical sensor device 220.

The arc signal 253 is a signal transmitted by the optical sensor device 220 to the arc detection controller 210, when the optical sensor device 220 detects light of an arc 251 produced by partial discharge. That is, the arc signal may be a signal transmitted when an arc actually occurs due to partial discharge in a heavy electric device such as an ultra-high voltage GIS, and the optical sensor device 220 detects the arc and notifies the arc to the arc detection controller 210.

In order for the arc detection controller 210 to distinguish the arc signal 253 for preventing a failure of the heavy electric device from the feedback self-checking optical signal 273, it is preferable that the self-checking optical signal 271 is generated to have a different pattern from a typical arc signal. A method by which the arc detection controller 210 generates the self-checking optical signal 271 to have a different pattern from a typical arc signal is as follows. In an embodiment, the arc detection controller 210 generates the self-checking optical signal 271 by previously analyzing the typical arc signal and making duties of the typical arc signal and the self-checking optical signal 271 significantly different from each other. For example, when an arc signal is detected as a signal having a duty of 2 us or including a pulse train, the self-checking optical signal 271 may be distinguished from the arc signal by being generated as a regular signal having a duty of exactly 50 us.

In an embodiment, while the arc detection controller 210 receives the feedback self-checking optical signal 273 from the optical sensor device 220, the arc detection controller 210 may determine that all of a transmission optical cable 231, a reception optical cable 233, and the optical sensor device 220 normally operate. After the arc detection controller 210 transmits the self-checking optical signal 271, it takes little time until the arc detection controller 210 receives the feedback self-checking optical signal 273 from the optical sensor device 220. This is because the self-checking optical signal 273 is an optical signal and thus there is little delay. Except for a calculation time required for a processor of the arc detection controller 210 to determine that the self-checking optical signal 271 is transmitted or the feedback self-checking optical signal 273 is received, a travel time itself of an optical signal may almost be negligible. Accordingly, when the arc detection controller 210 receives the feedback self-checking optical signal within a predetermined period of time (e.g., 100 us), the arc detection controller 210 may determine that the optical sensor device 220, the transmission optical cable 231, and the reception optical cable 233 normally operate.

In contrast, when the arc detection controller 210 does not receive the feedback self-checking optical signal 273 within the predetermined period of time after the self-checking optical signal 271 is transmitted, the processor included in the arc detection controller 210 determines that there is abnormality in at least one of the optical sensor device 220, the transmission optical cable 231, and/or the reception optical cable 233. According to an embodiment, a malfunction is notified to a system manager through a display (not shown) or a notification means (warning light) provided in the arc detection controller 210.

When the processor of the arc detection controller 210 does not receive the feedback self-checking optical signal 273 prior to a malfunction notification, a flag is set in an arc detection-related data field indicating that the optical sensor device 220 malfunctions or there is abnormality in at least one of the transmission optical cable 231 and/or the reception optical cable 233 and is maintained until a problem is solved or the flag is reset by a user. When the problem is solved and problem-solving data is received, the processor of the arc detection controller 210 may reset the flag in the arc detection-related data field.

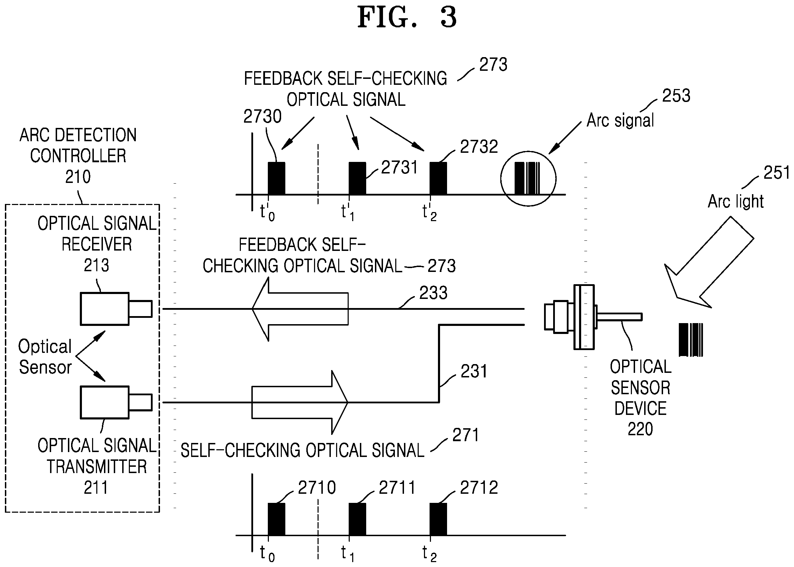

FIG. 3 is a view illustrating an arc detection self-checking apparatus, according to another embodiment of the present disclosure.

In an embodiment, referring to FIG. 3, in order to determine whether an arc detection operation is normally performed, the processor of the arc detection controller 210 may check whether a light amount value is constantly transmitted to and received from the optical sensor device 220.

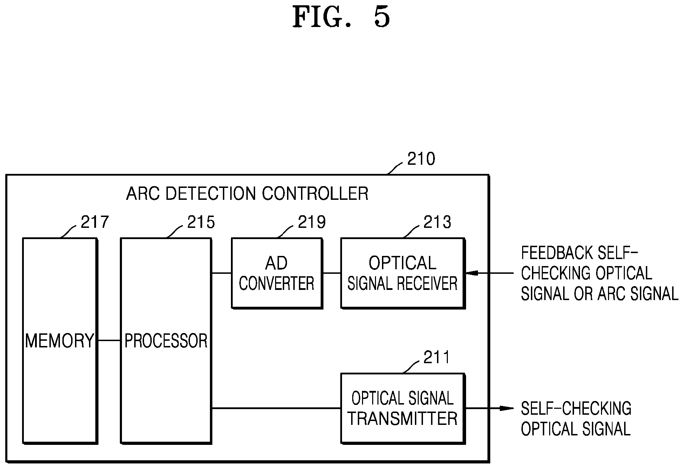

In order to describe the operation of FIG. 3, a block diagram of the arc detection controller 210 will be described first with reference to FIG. 5.

FIG. 5 is a block diagram illustrating the arc detection controller 210, according to an embodiment of the present disclosure.

Referring to FIG. 5, the arc detection controller 210 includes an optical signal transmitter 211 configured to transmit a self-checking optical signal to the optical sensor device 220, an optical signal receiver 213 configured to receive a feedback self-checking optical signal fed back when the optical sensor device 220 senses the transmitted self-checking optical signal, and a processor 215 configured to determine whether the optical sensor device 220 normally operates by determining whether the received feedback self-checking optical signal has a light amount value corresponding to a reference optical signal that is sent at an initial setting mode. Because one of reasons why the feedback self-checking optical signal does not have the light amount value corresponding to the reference optical signal sent at the initial setting mode may be damage to an optical cable configured to connect the arc detection controller 210 to the optical sensor device 220, determining whether the entire system normally operates, which is performed by the processor 215, includes determining whether the optical cable is damaged.

According to an embodiment, the optical signal receiver 213 may not only receive the feedback self-checking optical signal but also receive an arc signal transmitted when the optical sensor device 220 detects an arc.

According to an embodiment, the arc detection controller 210 may include a memory inside the processor 215, or a memory 217 for storing and reading data may be separately provided in the arc detection controller 210. The processor 215 may be provided as a separate processor outside the arc detection controller 210. According to an embodiment, the arc detection controller 210 may include an analog-to-digital (AD) converter 219 for converting a received optical signal into a digital value.

Referring back to FIG. 3, in an embodiment, the arc detection controller 210 generates a reference self-checking optical signal 2710 at a time to corresponding to an initial setting mode. The reference self-checking optical signal 2710 may be generated by the processor 215. For convenience of explanation, it is assumed that the reference self-checking optical signal 2710 is one of a plurality of the self-checking optical signals 271 in a broad sense. The processor 215 of the arc detection controller 210 generates the reference self-checking optical signal 2710 by controlling the amount of current flowing through an optical device or a voltage applied to both ends of the optical device to generate the reference self-checking optical signal 2710.

After generating the reference self-checking optical signal 2710, the arc detection controller 210 transmits the generated reference self-checking optical signal 2710 to the optical sensor device 220 through the transmission optical cable 231.

The optical sensor device 220 senses the transmitted reference self-checking optical signal 2710 and transmits a reference optical signal 2730 corresponding to the reference self-checking optical signal 2710 through an optical transmitter to the arc detection controller 210 through the reception optical cable 233, and the arc detection controller 210 receives the reference optical signal 2730. The processor 215 of the arc detection controller 210 converts a light amount value of the reference optical signal 2730 received from the optical transmitter of the optical sensor device 220 into a corresponding digital value through the AD converter 219, and stores the digital value as reference self-checking data in the memory 217. When the digital value is stored as the reference self-checking data in the memory 217, the initial setting mode ends.

In an embodiment, the digital value obtained by converting the light amount value of the received reference optical signal through the AD converter 219 may be a digital value obtained by converting the light amount value of the reference optical signal into a corresponding voltage value.

In the initial setting mode, the reference self-checking data corresponding to the light amount value of the reference optical signal received by the arc detection controller 210 is data indicating that the optical sensor device 220, the transmission optical cable 231, and the reception optical cable 2133 normally operate. In an embodiment, in order to improve the reliability of the reference self-checking data, the arc detection controller 210 may check whether a constant value is obtained within a certain range by repeatedly performing all steps from the step of generating the reference self-checking optical signal 2710 to the step of generating the reference self-checking data. In this case, the arc detection controller 210 may store, in the memory 217, the reference self-checking data within a predetermined error range by making the same environment for generating the reference self-checking optical signal. In an embodiment, when the same environment for generating the reference self-checking optical signal is made, it may mean that a voltage applied to an optical device, the amount of current flowing through the optical device, and a duty of an optical signal when the reference self-checking optical signal is generated are the same.

Once the reference self-checking data is stored in the memory 217, the arc detection controller 210 starts a checking mode. In the checking mode, the processor 215 of the arc detection controller 210 periodically generates self-checking optical signals 2711 and 2712 and transmit the self-checking optical signals 2711 and 2712 to the optical sensor device 220 through the transmission optical cable 231. In this case, the processor 215 periodically generates an event for generating the self-checking optical signals 2711 and 2712. The processor 215 generates the self-checking optical signals 2711 and 2712 under the same voltage and current condition and the same duty as the reference self-checking optical signal 2710.

In an embodiment, the processor 215 determines the amount of current flowing through an optical device to generate the self-checking optical signals 2711 and 2712 based on the generated event, and generates the self-checking optical signals 2711 and 2712 by controlling the determined amount of current to flow through the optical device. In another embodiment, the processor 215 determines a voltage applied to the optical device to generate the self-checking optical signals 2711 and 2712 based on the generated event, and generates the self-checking optical signals 2711 and 2712 by controlling the determined voltage to be applied to the optical device.

The optical sensor device 20 transmits an optical signal corresponding to the received self-checking optical signals 2711 and 2712 to the optical signal receiver 213 of the arc detection sensor 210 through the reception optical cable 233. For convenience, an optical signal corresponding to the self-checking optical signals 2711 and 2712 processed and then returned to the arc detection controller 210 by the optical sensor device 220 is referred to as the feedback self-checking optical signal 273. Sometimes, the feedback self-checking optical signal 273 may be mixed with the arc signal 253 and may be transmitted to the arc detection controller 210.

The arc signal 253 is a signal transmitted by the optical sensor device 220 to the arc detection controller 210, when the optical sensor device 220 detects light of an arc 251 that is a precursor of an actual failure. For example, when an arc actually occurs due to partial discharge in a heavy electric device such as an ultra-high voltage GIS, the optical sensor device 220 detects the arc and transmits an arc notification or the arc itself to detection controller 210. In order for the arc detection controller 210 to distinguish the arc signal 253 for preventing a failure of the heavy electric device from the feedback self-checking optical signal 273, it is preferable that the self-checking optical signal 271 is generated to have a pattern different from a typical arc signal. A method of generating the self-checking optical signal 271 having a different pattern from a typical arc signal is as follows. The processor 215 generates the self-checking optical signal 271 by previously analyzing the typical arc signal and making duties of the typical arc signal and the self-checking optical signal 271 significantly different from each other. When an arc signal is detected as a signal having a duty of 2 us or less or including a pulse train, the processor 215 may distinguish the self-checking optical signal 271 from the general arc signal by generating the self-checking optical signal 271 as a regular signal having a duty of 50 us. However, this is merely an example, and as long as the self-checking optical signal 271 and the reference self-checking optical signal 2710 may be distinguished from the arc signal, the processor 215 may generate the self-checking optical signal 271 to have an arbitrary duty value determined by a user's selection.

The AD converter 219 converts a light amount value of an optical signal received from the optical sensor device 220 into corresponding self-checking data. The processor 215 compares the self-checking data converted through the AD converter 219 with the reference self-checking data, and determines whether the optical sensor device 220, the transmission optical cable 231, and the reception optical cable 233 normally operate. In general, when the optical sensor device 220, the transmission optical sensor 231, and the reception optical sensor 233 are used for a long time, performance is reduced or degraded. Such performance reduction or degradation causes unexpected loss of an optical signal transmitted from the arc detection controller 210. Accordingly, when performance degradation or reduction occurs in any one of the optical sensor device 220, the transmission optical cable 231, and the reception optical cable 233, there is a difference between the reference self-checking data and the periodically obtained self-checking data.

When the difference between the reference self-checking data and the self-checking data is equal to or greater than a predetermined threshold value (e.g., a value corresponding to 10% of the reference self-checking data), the processor 215 determines that there is abnormality in any one of the optical sensor device 220, the transmission optical cable 231, and the reception optical cable 233. The processor 215 determines that a power system does not normally operates and outputs a failure notification through a display or a warning light.

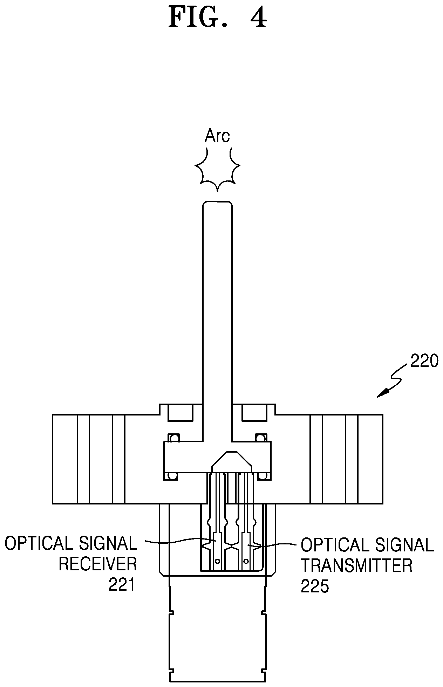

FIG. 4 is a view illustrating the optical sensor device 220, according to an embodiment of the present disclosure.

Referring to FIG. 4, the optical sensor device 220 includes an optical signal receiver 221 configured to receive the reference self-checking optical signal 2710 or the self-checking optical signals 2711 and 2712 transmitted by the arc detection controller 210, and an optical signal transmitter 225 configured to receive a detected arc from the optical signal receiver 221 and then transmit an arc signal, or sense the received reference self-checking optical signal 2710 or the self-checking optical signals 2711 and 2712 and then transmit a corresponding optical signal back to the arc detection controller 210.

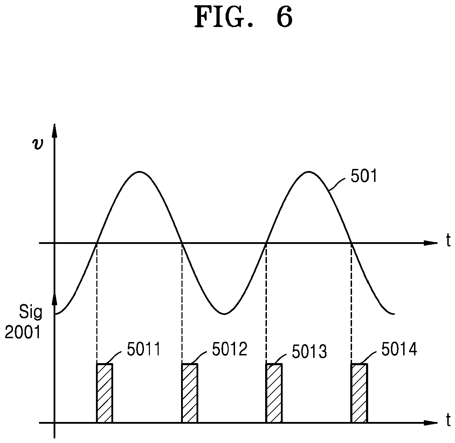

FIG. 6 is a diagram illustrating a time when the arc detection controller 210 generates a self-checking optical signal, according to an embodiment of the present disclosure.

A time when an arc produced by partial discharge in a power system is easily observed is when a voltage 501 of the power system is high. Accordingly, it is preferable that the arc detection controller 210 transmits the reference self-checking optical signal 2710 or the self-checking optical signals 2711 and 2712 to the optical sensor device 220 at a time other than a time when an arc is likely to occur. This is because, when the feedback self-checking signal 273 received from the optical sensor device 220 and an arc signal are mixed with each other, the arc detection controller 210 may fail to distinguish the two signals.

Accordingly, the processor 215 of the arc detection controller 210 generates the self-checking signal 271 and transmits the self-checking signal to the optical sensor device 220 at a time when a voltage of the power system is low. This transmission method may improve the self-checking reliability of the power system. Referring to FIG. 6, it is found that the arc detection controller 210 generates and/or transmits self-checking optical signals 5011, 5012, 5013, and 5014 at every point where an alternating current (AC) voltage 501 of the power system crosses zero. When the arc detection controller 210 generates and/or transmits the self-checking optical signals 5011, 5012, 5013, and 5014 in this way, mixing of an arc of the power system and the self-checking optical signals 5011, 5012, 5013, and 5014 may be prevented. However, this is merely an example, and the arc detection controller 210 may generate and transmit a self-checking optical signal in any of various ways by avoiding a high voltage point. In an embodiment, the arc detection controller 210 may transmit the self-checking optical signals 5011, 5012, 5013, and 5014 when a certain period of time (-a shortest possible time or a certain time-) elapses after the AC voltage 501 of the power system crosses zero and then it is determined that the zero-crossing is detected. Alternatively, the arc detection controller 210 may transmit the self-checking optical signal when a certain period of time elapses after the AC voltage 501 of the power system passes a highest point.

Alternatively, the processor 215 of the arc detection controller 210 may control the self-checking optical signals 5011, 5012, 5013, and 5014 to be transmitted to the optical sensor device 220 immediately after it is detected that an AC voltage of the power system to which the optical sensor device 220 belongs or an electric device to which the optical sensor device 220 is attached crosses zero. Alternatively, the processor 215 of the arc detection controller 210 may control the self-checking optical signals 5011, 5012, 5013, and 5014 to be transmitted when a certain period of time elapses after the AC voltage 501 of the power system crosses zero or to be transmitted when a certain period of time elapses after the AC voltage 501 of the power system passes a highest point.

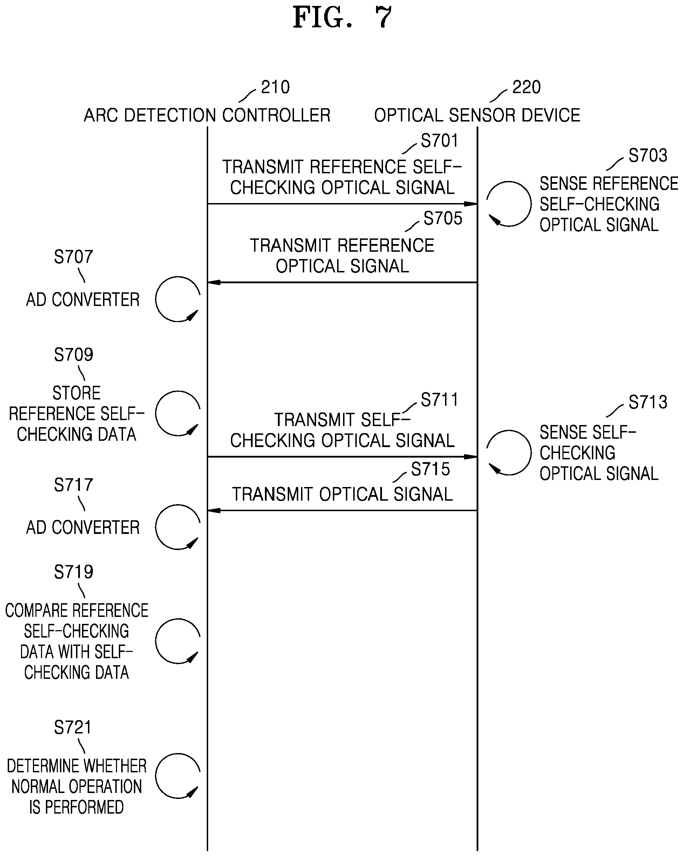

FIG. 7 is a flowchart illustrating a self-checking method of the arc detection controller 210, according to an embodiment of the present disclosure.

First, operations S701 through S709 correspond to an initial setting mode.

In operation S701, the arc detection controller 210 transmits a generated reference self-checking optical signal to the optical sensor device 220. In operation S703, the optical sensor device 220 senses the transmitted reference self-checking optical signal. In operation S705, the optical sensor device 220 transmits a reference optical signal corresponding to the reference self-checking optical signal to the arc detection controller 210 through an optical signal transmitter.

In operation S707, the arc detection controller 210 generates reference self-checking data by AD converting a light amount value corresponding to the received reference optical signal.

In operation S709, the arc detection controller 210 stores the reference self-checking data in the memory 217.

Operations S711 through S721 correspond to a checking mode.

In operation S711, the arc detection controller 210 generates a self-checking optical signal under the same condition as that of the reference self-checking signal, and transmits the self-checking optical signal to the optical sensor device 220 through the transmission optical cable 231.

In operation S713, the optical sensor device 220 senses the transmitted self-checking optical signal. In operation S715, the optical sensor device 220 transmits an optical signal corresponding to the self-checking optical signal to the arc detection controller 210 through the optical signal transmitter.

In operation S717, the arc detection controller 210 generates self-checking data by AD converting a light amount value of the received optical signal.

In operation S719, the processor 215 of the arc detection controller 210 compares the stored reference self-checking data with the generated self-checking data and determines whether there is a difference equal to or greater than a predetermined value.

In operation S721, when the stored reference self-checking data and the generated self-checking data are compared with each other and there is a difference equal to or greater than the predetermined value, the processor 215 of the arc detection controller 210 determines that there is abnormality in any one of the optical sensor device 220, the transmission optical cable 231, and the reception optical cable 233 and generates a failure notification.

Through the above process, a self-checking apparatus of an arc detection device including the arc detection controller 210, the optical sensor device 220, the transmission optical cable 231, and the reception optical cable 233 periodically transmits a self-checking signal corresponding to a predetermined light amount value to the optical sensor device 220, receives an optical signal corresponding to the self-checking signal from the optical sensor device 220, and determines whether there is abnormality in any of the optical sensor device 220, the transmission optical cable 231, and the reception optical cable 233 through a change in a light amount value corresponding to the received optical signal.

When a malfunction of an arc detection sensor device for detecting an arc of a high-power device is not detected in a timely manner, the stability of a power system may not be ensured. A method and apparatus according to the present disclosure may effectively ensure the stability of a power system by effectively detecting a malfunction of an arc detection sensor device.

## Claims

1. An arc detection device comprising:
an arc detection controller (210) comprising: a processor (215), a first optical signal transmitter (211) configured to transmit optical signals, a first optical signal receiver (213) configured to receive optical signals, and a memory; and
an optical sensor device (220), a reception optical cable (233), and a transmission optical cable (231);
wherein the processor (215) is configured to generate a reference self-checking optical signal in an initial setting mode,
to control the first optical signal transmitter (211) to transmit the reference self-checking optical signal to the optical sensor device through the transmission optical cable,
to control the first optical signal receiver (213) to, when the optical sensor device (220) senses the transmitted reference self-checking optical signal and generates a reference optical signal corresponding to the reference self-checking optical signal, receive the reference optical signal corresponding to the reference self-checking optical signal through the reception optical cable,
the memory (217) stores the reference self-checking data corresponding to the reference self-checking optical signal,
wherein, in a checking mode, the processor (215) is further configured to periodically generate a self-checking optical signal under a same condition as a condition of the reference self-checking optical signal and transmit the self-checking optical signal through the first optical signal transmitter to the optical sensor device through the transmission optical cable, and
when the optical sensor device (220) senses the transmitted self-checking optical signal and generates an optical signal corresponding to the self-checking optical signal, receive the optical signal corresponding to the self-checking optical signal through the first optical signal receiver,
the memory (217) stores self-checking data corresponding to the self-checking optical signal,
the processor (215) is further configured to determine whether a difference between the reference self-checking data corresponding to the reference self-checking optical signal and the self-checking data corresponding to the self-checking optical signal exceeds a predetermined threshold value,
determine, based on the difference exceeding the predetermined value, there is abnormality in any one of the optical sensor device, the transmission optical cable, and the reception optical cable;
wherein the optical sensor device (220) comprising:
a second optical signal receiver (221) configured to receive the self-checking optical signal transmitted from the arc detection controller,
an optical sensor configured to sense the received self-checking optical signal or an arc occurring in a power device, and
a second optical signal transmitter (225) configured to transmit the optical signal corresponding to the received self-checking optical signal to the arc detection controller, and
wherein the transmission optical cable (231) which connects the first optical signal transmitter to the second optical signal receiver; and the reception optical cable which connects the first optical signal receiver to the second optical signal transmitter.

2. The arc detection device of claim 1, wherein the arc detection controller further comprises an analog-to-digital (AD) converter (219) configured to generate the reference self-checking data by AD converting the light amount value corresponding to the reference optical signal to the reference self-checking data.

3. The arc detection device of claim 2, wherein the AD converter (219) is further configured to generate the self-checking data by AD converting the light amount value corresponding to the optical signal to the self-checking data.

4. The arc detection device of claim 1, wherein the periodically generating of the self-checking optical signal by the processor (215) comprises,
by the processor, periodically generating an event, generating the self-checking optical signal based on the generated event, and determining an amount of current flowing through an optical device to generate the self-checking optical signal, and
generating the self-checking optical signal by controlling the determined amount of current to flow through the optical device.

5. The arc detection device of claim 1, wherein the periodically generating of the self-checking optical signal by the processor comprises,
by the processor (215), periodically generating an event, generating the self-checking optical signal based on the generated event, and determining a voltage applied to an optical device to generate the self-checking optical signal, and
generating the self-checking optical signal by controlling the determined voltage to be applied to the optical device.

6. The arc detection device of claim 1, wherein the generating of the self-checking optical signal by the processor comprises
generating, by the processor (215), the self-checking optical signal having a duty of a predetermined value or longer to be distinguished from an arc signal.

7. A self-checking method in an arc detection device, the self-checking method comprising:
in an initial setting mode, generating a reference self-checking optical signal;
transmitting the reference self-checking optical signal to an optical sensor device (220) through a transmission optical cable (231);
when the optical sensor device (220) senses the transmitted reference self-checking optical signal and generates a reference optical signal corresponding to the reference self-checking optical signal, receiving, by a first optical signal receiver, the reference optical signal corresponding to the reference self-checking optical signal through a reception optical cable (233);
storing reference self-checking data corresponding to a light amount value corresponding to the reference optical signal;
in a checking mode, periodically generating a self-checking optical signal and transmitting the self-checking optical signal from an optical signal transmitter (211) to the optical sensor device (220) through the transmission optical cable (231);
when the optical sensor device (220) senses the transmitted self-checking optical signal and generates an optical signal corresponding to the self-checking optical signal, receiving, by the first optical signal receiver, the optical signal corresponding to the self-checking optical signal through the reception optical cable (233);
storing self-checking data corresponding to a light amount value of the optical signal corresponding to the received self-checking optical signal;
determining whether a difference between the reference self-checking data and the self-checking data exceeds a predetermined threshold value;
determining, based on the difference exceeding the predetermined value, there is abnormality in any one of the optical sensor device (220), the transmission optical cable (231), and the reception optical cable (233).

8. The self-checking method of claim 7, wherein the periodically generating of the self-checking optical signal in the checking mode comprises
periodically generating the self-checking optical signal under a same condition as a condition of generating the reference self-checking optical signal.

## Patentansprüche

1. Lichtbogenerkennungsvorrichtung, umfassend:
eine Lichtbogenerkennungssteuerung (210), umfassend: einen Prozessor (215), einen ersten optischen Signalsender (211), der zum Senden optischer Signale konfiguriert ist, einen ersten optischen Signalempfänger (213), der zum Empfangen optischer Signale konfiguriert ist, und einen Speicher; und
eine optische Sensorvorrichtung (220), ein optisches Empfangskabel (233) und ein optisches Sendekabel (231);
wobei der Prozessor (215) konfiguriert ist, um in einem anfänglichen Einstellmodus ein optisches Selbstkontroll-Referenzsignal zu erzeugen,
um den ersten optischen Signalsender (211) zu steuern, um das optische Selbstkontroll-Referenzsignal über das optische Sendekabel an die optische Sensorvorrichtung zu senden,
den ersten optischen Signalempfänger (213) zu steuern, um, wenn die optische Sensorvorrichtung (220) das gesendete optische Selbstkontroll-Referenzsignal erfasst und ein optisches Referenzsignal erzeugt, das dem optischen Selbstkontroll-Referenzsignal entspricht, das optische Referenzsignal, das dem optischen Selbstkontroll-Referenzsignal entspricht, über das optische Empfangskabel zu empfangen,
wobei der Speicher (217) die Selbstkontroll-Referenzdaten speichert, die dem optischen Selbstkontroll-Referenzsignal entsprechen,
wobei der Prozessor (215) in einem Kontrollmodus ferner konfiguriert ist, um periodisch ein optisches Selbstkontrollsignal unter einer gleichen Bedingung wie einer Bedingung des optischen Selbstkontroll-Referenzsignals zu erzeugen und das optische Selbstkontrollsignal durch den ersten optischen Signalsender über das optische Sendekabel an die optische Sensorvorrichtung zu senden, und
wenn die optische Sensorvorrichtung (220) das übertragene optische Selbstkontrollsignal erfasst und ein optisches Signal erzeugt, das dem optischen Selbstkontrollsignal entspricht, das optische Signal, das dem optischen Selbstkontrollsignal entspricht, über den ersten optischen Signalempfänger zu empfangen,
wobei der Speicher (217) Selbstkontrolldaten speichert, die dem optischen Selbstkontrollsignal entsprechen,
der Prozessor (215) ferner konfiguriert ist, um zu bestimmen, ob eine Differenz zwischen den Selbstkontroll-Referenzdaten, die dem optischen Selbstkontroll-Referenzsignal entsprechen, und den Selbstkontrolldaten, die dem optischen Selbstkontrollsignal entsprechen, einen vorbestimmten Schwellenwert überschreitet,
Bestimmen, basierend auf der Differenz, die den vorbestimmten Wert überschreitet, dass es eine Anomalie in einem von der optischen Sensorvorrichtung, dem optischen Sendekabel und dem optischen Empfangskabel gibt;
wobei die optische Sensorvorrichtung (220) Folgendes umfasst:
einen zweiten optischen Signalempfänger (221), der konfiguriert ist, um das von der Lichtbogenerkennungssteuerung übertragene optische Selbstkontrollsignal zu empfangen,
einen optischen Sensor, der konfiguriert ist, um das empfangene optische Selbstkontrollsignal oder einen in einer Stromversorgungsvorrichtung auftretenden Lichtbogen zu erfassen, und
einen zweiten optischen Signalsender (225), der konfiguriert ist, um das optische Signal, das dem empfangenen optischen Selbstkontrollsignal entspricht, an die Lichtbogenerkennungssteuerung zu senden, und
wobei das optische Sendekabel (231), das den ersten optischen Signalsender mit dem zweiten optischen Signalempfänger verbindet; und das optische Empfangskabel, das den ersten optischen Signalempfänger mit dem zweiten optischen Signalsender verbindet.

2. Lichtbogenerkennungsvorrichtung nach Anspruch 1, wobei die Lichtbogenerkennungssteuerung ferner einen Analog-Digital (AD)-Wandler (219) umfasst, der konfiguriert ist, um die Selbstkontroll-Referenzdaten durch AD-Wandlung des dem optischen Referenzsignal entsprechenden Lichtmengenwerts in die Selbstkontroll-Referenzdaten zu erzeugen.

3. Lichtbogenerkennungsvorrichtung nach Anspruch 2, wobei der AD-Wandler (219) ferner konfiguriert ist, um die Selbstkontrolldaten durch AD-Wandlung des dem optischen Signal entsprechenden Lichtmengenwerts in die Selbstkontrolldaten zu erzeugen.

4. Lichtbogenerkennungsvorrichtung nach Anspruch 1, wobei das periodische Erzeugen des optischen Selbstkontrollsignals durch den Prozessor (215) Folgendes umfasst,
durch den Prozessor, periodisches Erzeugen eines Ereignisses, Erzeugen des optischen Selbstkontrollsignals basierend auf dem erzeugten Ereignis und Bestimmen einer Strommenge, die durch eine optische Vorrichtung fließt, um das optische Selbstkontrollsignal zu erzeugen, und
Erzeugen des optischen Selbstkontrollsignals durch Steuern der bestimmten Strommenge, die durch die optische Vorrichtung fließt.

5. Lichtbogenerkennungsvorrichtung nach Anspruch 1, wobei das periodische Erzeugen des optischen Selbstkontrollsignals durch den Prozessor Folgendes umfasst,
durch den Prozessor (215), periodisches Erzeugen eines Ereignisses, Erzeugen des optischen Selbstkontrollsignals basierend auf dem erzeugten Ereignis und Bestimmen einer an eine optische Vorrichtung angelegten Spannung, um das optische Selbstkontrollsignal zu erzeugen, und
Erzeugen des optischen Selbstkontrollsignals durch Steuern der bestimmten Spannung, die an die optische Vorrichtung angelegt werden soll.

6. Lichtbogenerkennungsvorrichtung nach Anspruch 1, wobei das Erzeugen des optischen Selbstkontrollsignals durch den Prozessor Folgendes umfasst,
Erzeugen, durch den Prozessor (215), des optischen Selbstkontrollsignals mit einem Tastverhältnis von einem vorbestimmten Wert oder länger, um es von einem Lichtbogensignal zu unterscheiden.

7. Selbstkontrollverfahren in einer Lichtbogenerkennungsvorrichtung, das Selbstkontrollverfahren umfassend:
in einem anfänglichen Einstellungsmodus, Erzeugen eines optischen Selbstkontroll-Referenzsignals;
Senden des optischen Selbstkontroll-Referenzsignals über ein optisches Sendekabel (231) an eine optische Sensorvorrichtung (220);
wenn die optische Sensorvorrichtung (220) das übertragene optische Selbstkontroll-Referenzsignal erfasst und ein optisches Referenzsignal erzeugt, das dem optischen Referenzselbstkontrollsignal entspricht, Empfangen des optischen Referenzsignals, das dem optischen Referenzselbstkontrollsignal entspricht, durch einen ersten optischen Signalempfänger über ein optisches Empfangskabel (233);
Speichern von Selbstkontroll-Referenzdaten, die einem Lichtmengenwert entsprechen, der dem optischen Referenzsignal entspricht;
in einem Kontrollmodus, periodisches Erzeugen eines optischen Selbstkontrollsignals und Senden des optischen Selbstkontrollsignal von einem optischen Signalsender (211) über das optische Sendekabel (231) an die optische Sensorvorrichtung (220);
wenn die optische Sensorvorrichtung (220) das übertragene optische Selbstkontrollsignal erfasst und ein dem optischen Selbstkontrollsignal entsprechendes optisches Signal erzeugt, Empfangen des dem optischen Selbstkontrollsignal entsprechenden optischen Signals durch den ersten optischen Signalempfänger über das optische Empfangskabel (233);
Speichern von Selbstkontrolldaten, die einem Lichtmengenwert des optischen Signals entsprechen, das dem empfangenen optischen Selbstkontrollsignal entspricht;
Bestimmen, ob eine Differenz zwischen den Selbstkontroll-Referenzdaten und den Selbstkontrolldaten einen vorbestimmten Schwellenwert überschreitet;
Bestimmen, basierend auf der Differenz, die den vorbestimmten Wert überschreitet, dass es eine Anomalie in einem der optischen Sensorvorrichtung (220), dem optischen Sendekabel (231) und dem optischen Empfangskabel (233) gibt.

8. Selbstkontrollverfahren nach Anspruch 7, wobei das periodische Erzeugen des optischen Selbstkontrollsignals in dem Kontrollmodus Folgendes umfasst,
periodisches Erzeugen des optischen Selbstkontrollsignals unter denselben Bedingungen wie beim Erzeugen des optischen Selbstkontroll-Referenzsignals.

## Revendications

1. Dispositif de détection d'arc comprenant :
un contrôleur de détection d'arc (210) comprenant : un processeur (215), un premier émetteur de signaux optiques (211) configuré pour transmettre des signaux optiques, un premier récepteur de signaux optiques (213) configuré pour recevoir des signaux optiques, et une mémoire ; et
un dispositif de capteur optique (220), un câble optique de réception (233) et un câble optique de transmission (231) ;
dans lequel le processeur (215) est configuré pour générer un signal optique d'autocontrôle de référence dans un mode de réglage initial,
commander le premier émetteur de signaux optiques (211) afin de transmettre le signal optique d'autocontrôle de référence au dispositif de capteur optique par l'intermédiaire du câble optique de transmission,
commander le premier récepteur de signal optique (213) pour, lorsque le dispositif de capteur optique (220) détecte le signal optique d'autocontrôle de référence transmis et génère un signal optique de référence correspondant au signal optique d'autocontrôle de référence, recevoir le signal optique de référence correspondant au signal optique d'autocontrôle de référence par l'intermédiaire du câble optique de réception,
la mémoire (217) stocke les données d'autocontrôle de référence correspondant au signal optique d'autocontrôle de référence,
dans lequel, dans un mode de vérification, le processeur (215) est en outre configuré pour générer régulièrement un signal optique d'autocontrôle dans des conditions identiques à celles du signal optique d'autocontrôle de référence et transmettre le signal optique d'autocontrôle par le biais du premier émetteur de signal optique au dispositif de capteur optique par le biais du câble optique de transmission, et
lorsque le dispositif de détection optique (220) détecte le signal optique d'autocontrôle transmis et génère un signal optique correspondant au signal optique d'autocontrôle, recevoir le signal optique correspondant au signal optique d'autocontrôle par l'intermédiaire du premier récepteur de signal optique,
la mémoire (217) stocke les données d'autocontrôle correspondant au signal optique d'autocontrôle,
le processeur (215) est en outre configuré pour déterminer si une différence entre les données d'autocontrôle de référence correspondant au signal optique d'autocontrôle de référence et les données d'autocontrôle correspondant au signal optique d'autocontrôle dépasse une valeur seuil prédéterminée,
déterminer, sur la base de la différence dépassant la valeur prédéterminée, qu'il y a une anomalie dans l'un des dispositifs de détection optique, de câble optique de transmission et de câble optique de réception ;
dans lequel le dispositif de capteur optique (220) comprend :
un second récepteur de signal optique (221) configuré pour recevoir le signal optique d'autocontrôle transmis par le contrôleur de détection d'arc,
un capteur optique configuré pour détecter le signal optique d'autocontrôle reçu ou un arc électrique se produisant dans un dispositif d'alimentation, et
un second émetteur de signaux optiques (225) configuré pour transmettre le signal optique correspondant au signal optique d'autocontrôle reçu au contrôleur de détection d'arc, et
dans lequel le câble optique de transmission (231) relie le premier émetteur de signaux optiques au deuxième récepteur de signaux optiques ; et le câble optique de réception relie le premier récepteur de signaux optiques au second émetteur de signaux optiques.

2. Dispositif de détection d'arc selon la revendication 1, dans lequel le dispositif de commande de détection d'arc comprend en outre un convertisseur analogique-numérique (AN) (219) configuré pour générer les données d'autocontrôle de référence en convertissant d'AN la valeur de la quantité de lumière correspondant au signal optique de référence en données d'autocontrôle de référence.

3. Dispositif de détection d'arc selon la revendication 2, dans lequel le convertisseur AN (219) est en outre configuré pour générer les données d'autocontrôle en convertissant d'AN la valeur de la quantité de lumière correspondant au signal optique en données d'autocontrôle.

4. Dispositif de détection d'arc selon la revendication 1, dans lequel la génération régulière du signal optique d'autocontrôle par le processeur (215) comprend,
par le processeur, la génération régulière d'un événement, la génération du signal optique d'autocontrôle sur la base de l'événement généré, et la détermination d'une quantité de courant circulant à travers un dispositif optique pour générer le signal optique d'autocontrôle, et
la génération du signal optique d'autocontrôle en contrôlant la quantité déterminée de courant circulant dans le dispositif optique.

5. Dispositif de détection d'arc selon la revendication 1, dans lequel la génération régulière du signal optique d'autocontrôle par le processeur comprend,
par le processeur (215), la génération régulière d'un événement, la génération du signal optique d'autocontrôle sur la base de l'événement généré, et la détermination d'une tension appliquée à un dispositif optique pour générer le signal optique d'autocontrôle, et
la génération du signal optique d'autocontrôle en contrôlant la tension déterminée à appliquer au dispositif optique.

6. Dispositif de détection d'arc selon la revendication 1, dans lequel la génération du signal optique d'autocontrôle par le processeur comprend
la génération, par le processeur (215), du signal optique d'autocontrôle doté d'une durée de vie d'une valeur prédéterminée ou plus longue pour être distingué d'un signal d'arc.

7. Procédé d'autocontrôle dans un dispositif de détection d'arc, le procédé d'autocontrôle comprenant :
dans un mode de réglage initial, la génération d'un signal optique d'autocontrôle de référence ;
la transmission du signal optique d'autocontrôle de référence à un dispositif de capteur optique (220) par l'intermédiaire d'un câble optique de transmission (231) ;
lorsque le dispositif de capteur optique (220) détecte le signal optique d'autocontrôle de référence transmis et génère un signal optique de référence correspondant au signal optique d'autocontrôle de référence, la réception, par un premier récepteur de signal optique, du signal optique de référence correspondant au signal optique d'autocontrôle de référence par l'intermédiaire d'un câble optique de réception (233) ;
le stockage des données d'autocontrôle de référence correspondant à une valeur de quantité de lumière correspondant au signal optique de référence ;
dans un mode de vérification, la génération régulière d'un signal optique d'autocontrôle et la transmission du signal optique d'autocontrôle d'un émetteur de signal optique (211) au dispositif de capteur optique (220) par l'intermédiaire du câble optique de transmission (231) ;
lorsque le dispositif de détection optique (220) détecte le signal optique d'autocontrôle transmis et génère un signal optique correspondant au signal optique d'autocontrôle, la réception, par le premier récepteur de signal optique, du signal optique correspondant au signal optique d'autocontrôle par l'intermédiaire du câble optique de réception (233) ;
le stockage de données d'autocontrôle correspondant à une valeur d'intensité lumineuse du signal optique correspondant au signal optique d'autocontrôle reçu ;
la détermination si la différence entre les données d'autocontrôle de référence et les données d'autocontrôle dépasse une valeur seuil prédéterminée ;
la détermination, sur la base de la différence dépassant la valeur prédéterminée, qu'il existe une anomalie dans l'un ou l'autre du dispositif de détection optique (220), du câble optique de transmission (231) et du câble optique de réception (233).

8. Procédé d'autocontrôle selon la revendication 7, dans lequel la génération régulière du signal optique d'autocontrôle en mode de contrôle comprend
la génération régulière du signal optique d'autocontrôle dans des conditions identiques à celles de la génération du signal optique d'autocontrôle de référence.
